Europäisches Patentamt

European Patent Office

Office européen des brevets

(19)

(11) **EP 1 286 392 A2**

(12) **EUROPEAN PATENT APPLICATION**

(43) Date of publication:
26.02.2003 Bulletin 2003/09

(51) Int Cl.$^7$: **H01L 21/762**

(21) Application number: **02255858.9**

(22) Date of filing: **22.08.2002**

| | |
|---|---|
| (84) Designated Contracting States:<br>**AT BE BG CH CY CZ DE DK EE ES FI FR GB GR IE IT LI LU MC NL PT SE SK TR**<br>Designated Extension States:<br>**AL LT LV MK RO SI** | (71) Applicant: **SEIKO EPSON CORPORATION**<br>**Shinjuku-ku, Tokyo 163-0811 (JP)** |
| (30) Priority: **23.08.2001 JP 2001253485**<br>**14.06.2002 JP 2002174965** | (72) Inventor: **Yamazaki, Yasushi**<br>**Suwa-shi, Nagano-ken 392-8502 (JP)** |
| | (74) Representative: **Sturt, Clifford Mark et al**<br>**Miller Sturt Kenyon**<br>**9 John Street**<br>**London WC1N 2ES (GB)** |

(54) **Method for manufacturing semiconductor substrate, semiconductor substrate, electrooptic device and electronic apparatus**

(57)    A method for manufacturing a semiconductor substrate is provided, and according to this method, a semiconductor substrate having the SOI structure composed of a supporting substrate and an SOI layer, which have thermal expansion coefficients different from each other, can be formed. In addition, a semiconductor substrate, and an electrooptic device and an electronic apparatus are also provided.

When a substrate 600 having the SOI structure is formed, a groove 260 is formed in a single crystal silicon layer, so that island-shaped single crystal silicon layers 230 are formed. Subsequently, heat treatment is performed. Consequently, since thermal stress caused by the difference in thermal expansion coefficient between a supporting substrate 500 and the single crystal silicon layer 230 is reduced by the groove 260, even when heat treatment for improving a bonding strength or an oxidation step is performed, a high-quality single crystal silicon layer having no dislocation and cracks therein can be obtained.

FIG. 2

**EP 1 286 392 A2**

**Description**

The present invention relates to methods for manufacturing semiconductor substrates having the SOI structure, semiconductor substrates manufactured by the above methods, and electrooptic devices and electronic apparatuses using these semiconductor substrates. In more detail, the present invention relates to a technique for forming the SOI structure in a semiconductor substrate.

According to SOI (silicon on insulator) techniques for forming semicondunter devices using a silicon layer provided on an insulating layer, a semiconductor device having superior properties, such as alpha particle resistance, latch-up resistance, or reduction of short-channel effect, which cannot be achieved by using a conventional single crystal silicon substrate, can be obtained; hence, development of the SOI techniques has been progressing for achieving higher integration of semiconductor devices.

Recently, superior reduction of short-channel effect has been obtained in a device formed on an SOI layer having a thickness decreased to 100 nm or less. The SOI device thus formed has various advantages such as high reliability because of radiation resistance, and high-speed operation and low electrical power consumption due to the reduction of parasite capacitance, and in addition, since a perfect depletion type field effect transistor can be formed, the trend toward fine process rule can be achieved.

As a method for forming the SOI structure described above, a bonding method may be mentioned in which SOI substrates are formed by bonding a single crystal silicon substrate. In this so-called bonding method, after a single crystal silicon substrate and a supporting substrate are laminated to each other with an oxide film provided therebetween and are then bonded together using OH groups present on the surface of the substrate at approximately room temperature, the single crystal silicon substrate is processed by grinding, polishing, or etching to decrease the thickness thereof and is then processed by heat treatment at approximately 700 to 1,200°C for increasing bonding strength by forming siloxane bonds (Si-O-Si), thereby forming a single crystal silicon layer on the supporting substrate. In this method, since a single crystal silicon substrate is directly processed so that the thickness thereof is decreased, the crystallinity of the silicon thin-film is superior, and hence a high-performance device can be formed (Takao Abe, "Silicon" BAIFUKAN CO., LTD., p. 330).

In addition, as a modified method using this bonding method, for example, there may be a method comprising steps of implanting hydrogen ions into a single crystal silicon substrate, bonding this silicon substrate to a supporting substrate, performing heat treatment at approximately 400 to 600°C so that a thin-film silicon layer is divided from the single crystal silicon substrate at the hydrogen implanted area thereof, and subsequently performing heat treatment at approximately 1,100°C for increasing the bonding strength (M. Bruel et al., Electrochemical Soc. Proc. Vol. 97-27, p. 3), or a method comprising epitaxially growing a single crystal silicon layer on a silicon substrate with a porous surface, bonding this epitaxially grown layer on the substrate to a supporting substrate and then removing the substrate, and etching the porous silicon layer, thereby forming an epitaxial single crystal silicon thin-film on the supporting substrate (Japanese Unexamined Patent Application Publication No. 4-346418).

SOI substrates formed by the bonding method can be used for forming various devices(semiconductor integrated circuits) as well as general bulk semiconductor substrates; however, as one of the points of difference from a conventional bulk substrate, there may be mentioned that various materials can be used for forming a supporting substrate. That is, as the supporting substrate, in addition to a general silicon substrate, a quartz substrate, a glass substrate, or the like, having light transparency may be used. Accordingly, when a single crystal silicon thin-film is formed on a light-transparenct substrate, for example, in devices necessary to have light transparency such as an electrooptic device including a transmissive liquid crystal device or the like, a high-performance transistor element can be formed from a single crystal silicon layer having superior crystallinity on an active matrix substrate. That is, by forming pixel switching MIS transistors for driving pixel electrodes or drive circuit MIS transistors for forming drive circuits in the periphery of an image display region on an SOI layer, which is a single crystal silicon layer, finer image resolution and higher-speed operation can be achieved.

When SOI substrates are used for electrooptic devices such as a transmissive liquid crystal, since the thermal expansion coefficient of the SOI layer is different from that of a light transparent substrate such as a quartz substrate, which is a supporting substrate, in a semiconductor process such as the heat treatment described above for improving the bonding strength or an oxidation step performed at approximately 900 to 1,100°C, thermal stress is generated due to the difference in thermal expansion coefficient, misfit dislocation or cracking occurs in the SOI layer, and as a result, device properties may be degraded in some cases. In particular, the problem described above may become serious when the thickness of the SOI layer is large (for example, a SOI layer having a thickness of 0.5 $\mu$m or more when the supporting substrate is a quartz substrate having a thickness of 525 $\mu$m) (T. Abe et al., Jpn. J. Appl. Phys. 32, (1993), p. 334).

In an SOI substrate used for a liquid crystal device, it is preferable that a single crystal silicon layer forming pixel switching MIS transistors in an image display region be extremely thin in order to suppress light leakage current, and in particular, it is preferably 100 nm or less. In contrast, since a drive circuit MIS transistor is required to have high-speed performance, a single crystal silicon layer forming drive circuit MIS transistors preferably has low sheet resistance. Accordingly, the single crystal silicon layer in the periphery of the image display region is preferably formed to be thick, and more preferably, it is approximately 200 to 400 nm.

In order to form a single crystal silicon layer having a different thickness in one part, a method may be mentioned in which a surface of a single crystal silicon substrate is selectively oxidized, and a sacrifice oxide film formed by this surface oxidation is then removed by wet etching. According to this method, after the sacrifice oxide film is removed, in the region on which the sacrifice oxide film was previously formed, a thin single crystal silicon film remains. On the other hand, in the region on which the sacrifice layer was not previously formed, a thick single crystal silicon film remains.

However, since the SOI substrate, which is effectively used for a liquid crystal device, has a thermal expansion coefficient different from that of a supporting substrate, it is difficult by the reason described above to use a method for forming a single crystal silicon layer having a different thickness in one part by sacrifice oxidation.

In addition, for forming a bonded SOI substrate, high-temperature annealing is effectively used for improving the bonding strength; however, by the same reason as described above, heat treatment at approximately 700 to 1,200°C necessary for obtaining sufficient bonding strength cannot be performed.

In consideration of the problems described above, an object of the present invention is to provide a method for manufacturing a semiconductor substrate comprising an SOI layer, which will not generate defects in a high-temperature process, using an SOI substrate composed of a supporting substrate and the SOI layer having a different thermal expansion coefficient therefrom; a semiconductor substrate manufactured by the method described above; and an electrooptic device and an electronic apparatus using the semiconductor substrate described above.

To these ends, in a method of the present invention for manufacturing a semiconductor substrate having a supporting substrate which has a first thermal expansion coefficient, an insulating layer formed on the supporting substrate, and a single crystal semiconductor layer which is formed on the insulating layer and which has a second thermal expansion coefficient, the method comprises forming the single crystal semiconductor layer, forming a groove in the periphery of a predetermined region of the single crystal semiconductor layer, and subsequently performing heat treatment.

According to the structure of the present invention, since the groove is formed in the periphery of the predetermined region of the single crystal semiconductor layer, even when thermal stress caused by the difference in thermal expansion coefficient is generated, the thermal stress can be reduced by the groove region.

Accordingly, in an SOI substrate composed of a supporting substrate and a semiconductor layer, which have thermal expansion coefficients different from each other, even when heat treatment such as an oxidation step is performed, a semiconductor substrate comprising a single crystal semiconductor layer with no defects can be manufactured.

As a result, since a single crystal semiconductor layer having thicknesses optimum for individual semiconductor devices formed on a semiconductor substrate can be provided, designing can be flexibly performed in which, among various semiconductor devices formed on the semiconductor substrate, a semiconductor device driven by a high current and at high frequency is formed on a thick second single crystal semiconductor layer, and a semiconductor device driven by a low voltage is formed on a thin first single crystal semiconductor layer. Accordingly, properties of semiconductor devices formed on the single crystal semiconductor layer can be fully obtained.

In addition, in a bonded SOI substrate, high-temperature annealing can be performed for increasing the bonding strength.

In the method described above for manufacturing the semiconductor substrate, the heat treatment is preferably performed in the range of 700 to 1,200°C.

According to the structure of the present invention, the adhesion strength of the bonded SOI substrate can be sufficiently increased by heat treatment. In addition, thermal stress is reduced by the grooves thus formed, and hence no defects occur.

In the method for manufacturing the semiconductor substrate, the periphery of the predetermined region is preferably the outside periphery of the semiconductor substrate. In the present invention, the semiconductor substrate means each IC chip obtained from a semiconductor mother substrate by dicing.

According to the structure of the present invention, since the region in which the groove is formed in the single crystal semiconductor layer is a region where the semiconductor substrate is diced, the layout of the semiconductor substrates is not affected, and hence circuit designing can be optionally performed.

In the method for manufacturing the semiconductor substrate, the periphery of the predetermined region is preferably an element isolation region.

According to the structure of the present invention, since a plurality of grooves is formed in the single crystal semiconductor layer, thermal stress can be reliably reduced. In addition, since the grooves can be formed in an element isolation step, advantage in that the number of steps is not increased can be obtained.

In the method for manufacturing the semiconductor substrate, the width of the groove is preferably larger than the difference in thermal expansion generated between the supporting substrate having the first thermal expansion coefficient and the single crystal semiconductor layer having the second thermal expansion coefficient in the predetermined region during a first heat treatment of the semiconductor substrate.

According to the structure of the present invention, since the width of the groove is larger than the difference in thermal expansion generated during the first heat treatment described above, the difference in the thermal expansion is absorbed in the groove, and hence the thermal stress caused by the difference in thermal expansion coefficient can be reduced.

In the method for manufacturing the semiconductor substrate, the heat treatment described above is preferably performed in an oxidizing atmosphere.

According to the structure of the present invention, a step of increasing the bonding strength of the bonded SOI substrate by heat treatment may also be used as an oxidation step for various purposes.

In the method for manufacturing the semiconductor substrate, the thickness of the single crystal semiconductor layer is preferably adjusted in a high-temperature annealing in the oxidizing atmosphere.

According to the structure of the present invention, since the oxidation step of adjusting the thickness of the single crystal semiconductor layer can also be used as the annealing step of increasing the bonding strength, the advantage in that the number of steps is not increased can be obtained.

In a method of the present invention for manufacturing a semiconductor substrate having a supporting substrate which has a first thermal expansion coefficient, an insulating layer formed on the supporting substrate, and a single crystal semiconductor layer which is formed on the insulating layer and which has a second thermal expansion coefficient, the method comprises performing heat treatment of the semiconductor substrate in the state in which the temperature in the semiconductor substrate is increased in the direction toward one of the supporting substrata having the first thermal expansion coefficient and the single crystal semiconductor layer having the second thermal expansion coefficient, whichever has a lower thermal expansion coefficient.

According to the structure of the present invention, since the thermal expansions of the supporting substrate and the semiconductor substrate become approximately equivalent to each other, the thermal stress at a high temperature is reduced. In addition, when the grooves are formed in predetermined regions of the single crystal semiconductor layer, it is naturally understood that the thermal stress can be more easily reduced.

A semiconductor substrate of the present invention comprises a supporting substrate which has a first thermal expansion coefficient, an insulating layer formed on the supporting substrate, and a single crystal semiconductor layer which is formed on the insulating layer and which has a second thermal expansion coefficient, wherein at least a part of the insulating layer is formed of a material having at least fluidity or elasticity during heat treatment at 1,200°C or less.

According to the structure of the present invention, even when the difference in thermal expansion is generated during heat treatment, since at least the part of the insulating layer has fluidity or elasticity, the thermal stress can be reduced. Accordingly, the thermal stress can be reduced even when a groove, which is another structure of the present invention, is not formed. When necessary, the groove may be formed.

In the semiconductor substrate formed by the manufacturing method or the semiconductor substrate, described above, the single crystal semiconductor layer preferably comprises single crystal silicon. In addition to single crystal silicon, single crystal germanium or the like may also be used as a single crystal semiconductor layer.

In the semiconductor substrate formed by the manufacturing method or the semiconductor substrate, described above, various materials may be used for the supporting substrate. That is, as the supporting substrate, a light transparent substrate, such as a quartz substrate or a glass substrate having light transparency, may be used. Accordingly, when a single crystal semiconductor layer is formed on a light transparent substrate, in devices that must have light transparency such as an electrooptic device including a transmissive liquid crystal device, a high-performance transistor element can be formed on an active matrix substrate using the single crystal semiconductor layer having superior crystallinity. That is, by forming pixel switching MIS transistors for driving pixel electrodes or drive circuit MIS transistors for forming drive circuits in the periphery of an image display region, on an SOI layer which is a single crystal silicon layer, finer image and higher-speed operation can be realized.

When a glass substrate is used as the supporting substrate, for example, the present invention can be applied to a relatively inexpensive and common device such as a liquid crystal device.

In addition, when a quartz substrate is used as the supporting substrate, since heat resistance of the supporting substrate is superior, in a process for forming a device on a single crystal semiconductor substrate, high-temperature heat treatment can be performed. For example, by using a process such as heat treatment for improving semiconductor device properties of MIS transistors or the like, formation of a thermal oxide film, or high-temperature annealing, a high-performance semiconductor device can be formed on a semiconductor substrate.

In the semiconductor substrate described above, the width of the groove formed in the outside periphery of the semiconductor substrate is preferably 120 μm or more.

According to the structure of the present invention, in the case in which the supporting substrate is made of quartz and the single crystal semiconductor layer is made of silicon, even when a square-shaped semiconductor substrate having one side 40 mm long, the difference in thermal expansion generated by heat treatment at 1,200°C can be reduced by the groove described above.

In the semiconductor substrate described above, the width of the groove formed in the element isolation region is preferably 0.1 μm or more.

According to the structure of the present invention, in the case in which the supporting substrate is made of quartz and the single crystal semiconductor layer is made of silicon, even when a square-shaped semiconductor element having one side 25 μm long, the difference in thermal expansion generated by heat treatment at 1,200°C can be reduced by the groove described above.

The semiconductor substrate of the present invention can be applied for forming various semiconductor devices, and for example, an electrooptic device such as a liquid crystal device can be formed.

In the case described above, in an electrooptic device comprising an electrooptic material provided between a semiconductor substrate and a counter substrate, a plurality of first switching elements formed in a matrix in an image display region of the single crystal semiconductor layer above the supporting substrate so as to correspond to arranged pixels, and a plurality of second switching elements which are disposed in a peripheral region of the image display region and which form at least a part of a peripheral circuit, the thickness of the single crystal semiconductor layer which is in the image display region and forms said plurality of the first switching elements is preferably smaller than the thickness of the single crystal semiconductor layer which is in the peripheral region and forms said plurality of the second switching elements. According to the structure described above, since the single crystal semiconductor layer forming the pixel switching MIS transistors is thin, a leak current generated by the photoelectric effect due to incident light can be suppressed. In addition, since sheet resistance of the single crystal semiconductor layer in the drive circuit can be decreased to a low level, degradation of properties is unlikely to occur even under high current or high-frequency driving conditions. As a result, the reliability of the drive circuit MIS transistor can be increased.

An electronic apparatus of the present invention comprises a light source; the electrooptic device modulating light incident thereon from the light source in accordance with image information; and projection means for projecting light modulated by the electrooptic device.

Embodiments of the present invention will now be described by way of further example only and with reference to the accompanying drawings, in which:-

Figs. 1(A) to (D) are each cross-sectional view showing a step of a method for manufacturing a semiconductor substrate of Embodiment 1 according to the present invention.

Figs. 2(A) to (C) are each cross-sectional view showing a step of a method for manufacturing a semiconductor substrate of Embodiment 1 according to the present invention and a modification thereof.

Fig. 3 is a plan view showing a liquid crystal device of Embodiment 3 according to the present invention and various constituent elements formed thereon when they are viewed from a counter substrate side.

Fig. 4 is a cross-sectional view taken along the line H-H' in Fig. 3.

Fig. 5 is an equivalent diagram of various elements, wires, and the like formed on a plurality of pixels disposed in a matrix in an image display region of a liquid crystal device.

Fig. 6 is a plan view showing the structure of each pixel formed on an active matrix substrate of a liquid crystal device.

Fig. 7 is a cross-sectional view of a part of the image display region of the liquid crystal device shown in Figs. 3 and 4 taken along the line A-A' in Fig. 6.

Fig. 8 is a plan view of a circuit formed in a peripheral region of the image display region of the liquid crystal device shown in Figs. 3 and 4.

Fig. 9 is a cross-sectional view of the drive circuit MIS transistor shown in Fig. 8.

Figs. 10(A) to (D) are cross-sectional views showing steps of a method for manufacturing an active matrix substrate which is used for the liquid crystal device shown in Figs. 3 and 4.

Figs. 11(A) to (C) are cross-sectional views showing steps of a method for manufacturing the active matrix substrate which is used for the liquid crystal device shown in Figs. 3 and 4.

Figs. 12(A) to (C) are cross-sectional views showing steps of a method for manufacturing the active matrix substrate which is used for the liquid crystal device shown in Figs. 3 and 4.

Figs. 13(A) to (C) are cross-sectional views showing steps of a method for manufacturing the active matrix substrate which is used for the liquid crystal device shown in Figs. 3 and 4.

Figs. 14(A) and (B) are cross-sectional views showing steps of a method for manufacturing the active matrix substrate which is used for the liquid crystal device shown in Figs. 3 and 4.

Fig. 15 is a block diagram showing a circuit configuration of an electronic apparatus using a liquid crystal device of the present invention as a display portion.

Fig. 16 is a cross-sectional view showing an optical configuration of a projection type electrooptic device as an example of an electronic apparatus using a liquid crystal device of the present invention.

[Embodiment 1]

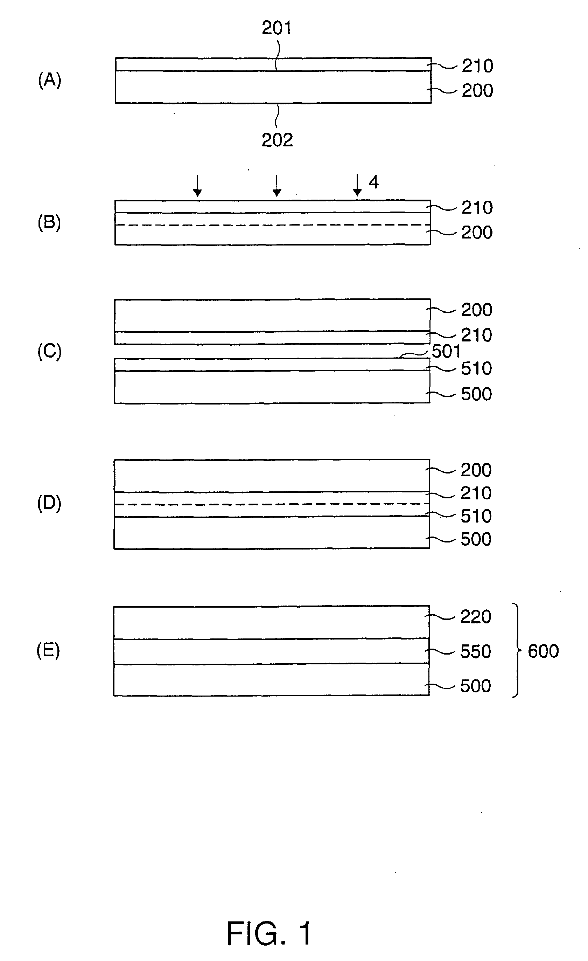

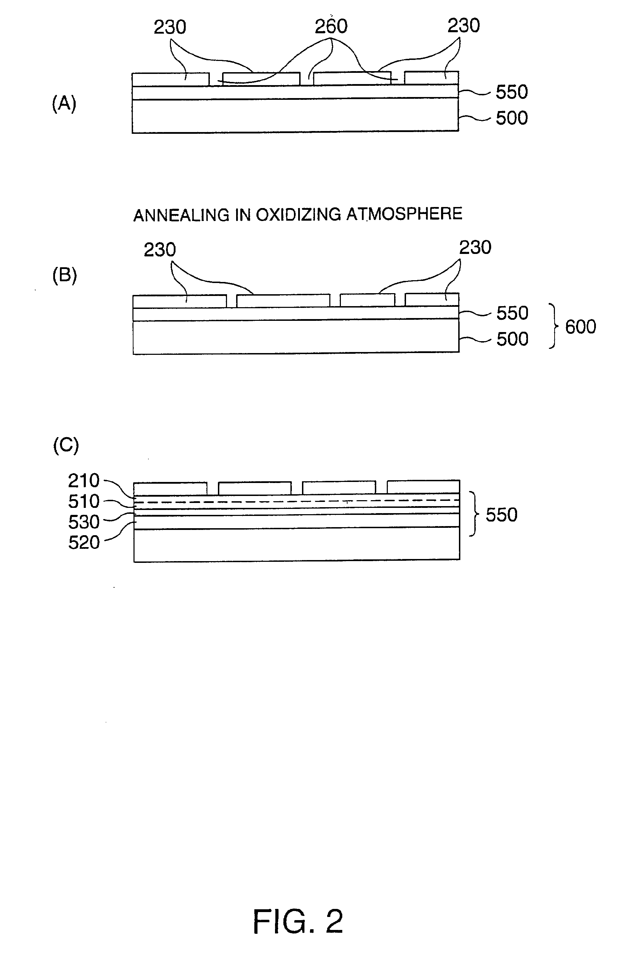

Figs. 1(A) to (E) and Figs. 2(A) and (B) are each a cross-sectional view showing a step of the manufacturing method for a semiconductor substrate (bonded substrate) having the SOI structure according to embodiment 1 of the present invention.

In this embodiment, as shown in Fig. 1(A), after a single crystal silicon substrate 200 (single crystal semiconductor substrate) having a thickness of 750 $\mu$m is first prepared, of a first surface 201 and a second surface 202 thereof, a silicon oxide film 210 is formed on at least the entire first surface 201. In a bonding step, this silicon oxide film 210 may have a thickness enabling the first surface 201 to have hydrophilic properties or more; however, in consideration of device properties, for example, the thickness thereof is formed to be approximately 200 to 400 nm.

Next, as shown in Fig. 1(B), hydrogen ions 4 are implanted from the first surface 201 side into the single crystal silicon substrate 200 provided with the silicon oxide film 210. As a result, an ion implanted layer having the distribution of penetration depth (average value of the distribution of penetration depth is shown by the dotted line in Fig. 1(B)) is formed inside the single crystal silicon substrate 200. The ion implantation conditions for this step are that, for example, the accelerating energy is 60 to 150 KeV, and the dose rate is 5 x $10^{16}$ to 10 x $10^{16}$ cm$^{-2}$.

Next, as shown in Fig. 1(C), after a supporting substrate 500 is prepared, and an oxide film 510 such as a silicon oxide film or an NSG (non-doped silicate glass) film is formed by sputtering or CVD on the entire surface of the supporting substrate 500, the surface of the oxide film 510 is preferably planarized by polishing using a CMP method or the like. In this step, the oxide film 510 is formed having a thickness of, for example, approximately 400 to 1,000 nm, and more preferably, approximately 800 nm. In this case, when the supporting substrate is a substrate primarily composed of $SiO_2$ such as quartz, the step of forming an oxide film may be omitted.

These oxide films 210 and 510 are formed to ensure the adhesion between the single crystal silicon substrate 200 and the supporting substrate 500. The supporting substrate 500 may be formed of a substrate having light transparency such as glass or quartz glass. As the supporting substrate 500, when a material having light transparency, such as glass or quartz glass, is used, the present invention can be applied to transmissive electrooptic devices or the like.

Next, as shown in Fig. 1(D), the first surface 201 of the single crystal silicon substrate 200 and the surface of the supporting substrate 500 are placed so that the insulating films 210 and 510 form a joint surface and are then bonded to each other at approximately room temperature to 200°C. As a result, by using OH groups present on the surface of the substrate, as shown in Fig. 1(E), a bonded substrate 600 (semiconductor substrate) composed of a single crystal silicon layer 220 and the supporting substrate 500 bonded thereto with an insulating film 550 (oxide films 210 and 510) therebetween is formed. When heat treatment is performed at a low temperature such as 400 to 600°C, the single crystal silicon substrate 200 is divided along the position of the ion implanted layer, and as a result, the single crystal silicon layer 220 is obtained. This phenomenon described above occurs since the bonds of semiconductor crystal is broken by the ions implanted into the single crystal silicon substrate 200, and this bond breakage particularly occurs at the position at which the ion concentration in the ion implanted layer is maximum. Accordingly, the position at which the division of the single crystal silicon substrate occurs by heat treatment coincides with the position of the maximum ion concentration described above. In this step, since the surface of the single crystal silicon layer 220 obtained by the division described above has irregularities of approximately several nanometers, it is preferable that planarization be performed by a CMP method or a hydrogen annealing method in which heat treatment is performed in a hydrogen atmosphere.

In addition, on the surface of the supporting substrate 500, a film composed of molybdenum or tungsten may be formed at the lower side of the oxide film 510. The film mentioned above serves as, for example, a thermal conductive film, and hence the temperature distribution in the supporting substrate 500 can be improved. Accordingly, for example, in a step of bonding the supporting substrate 500 and the single crystal silicon substrate 200 to each other, since the temperature distribution at the interface therebetween becomes uniform by this thermal conductive film, the bonding at this interface can be uniformly performed, and hence the bonding strength can be improved. Furthermore, when the bonded substrate is used for a transmissive liquid crystal device or the like, the film composed of molybdenum, tungsten, or the like also serves as a shading layer. As a material can be used for forming the film described above, in addition to the materials described above, there may be mentioned a high melting point metal such as tantalum, cobalt, or titanium, or an alloy thereof; a polycrystalline silicon film; or a silicide film such as tungsten silicide or molybdenum silicide.

Next, as shown in Fig. 2(A), the single crystal silicon layer 220 is patterned by a photolithographic technique to form grooves in the single crystal silicon layer, thereby forming island-shaped single crystal silicon layers 230. In the step described above, the grooves 260 in the single crystal silicon layer 230 are preferably formed in peripheral regions (dicing regions) of individual semiconductor substrates, which are formed on a semiconductor mother substrate, or in element isolation regions for semiconductor elements formed on the single crystal silicon layer 230. In addition, the width of the groove is preferably larger than a thermal expansion difference between the single crystal layer 230 and the supporting substrate 500 generated when the semiconductor substrate 600 is annealed. In this embodiment, the thermal expansion difference is the product of the absolute value of the difference in thermal expansion coefficient of the supporting substrate from that of the single crystal silicon layer, the size of the single crystal silicon layer, and the change of temperature, and is obtained by the equation below:

[Equation 1]     thermal expansion coefficient of the supporting substrate - thermal expansion coefficient of the single crystal silicon substrate $| \times$ the size of the single crystal silicon

layer $\times$ change of temperature.

In the above equation 1, the size of the single crystal silicon layer is the length in the width direction of the groove in the single crystal silicon layer. Related to this, in general, the thermal expansion difference depends on the thickness of the single crystal silicon layer; however, since the thickness of the single crystal silicon layer is very thin, such as approximately one thousandth of that of the supporting substrate, the influence thereof is very small. Consequently, when the thermal expansion difference is calculated, the thickness of the single crystal silicon layer can be ignored. In addition, a groove having a width actually larger to some extent than the thermal expansion difference obtained by the above equation is preferably formed for the sake of safety.

Furthermore, for example, in the case in which silicon layers adjacent to each other have a different size from each other, the actual width of the groove must be determined in consideration of the thermal expansion difference between the single crystal silicon layers adjacent to each other. In this case, based on one single crystal silicon layer, the thermal expansion thereof different from that of the supporting substrate is calculated (this value is referred to as thermal expansion difference 1). Next, based on the other single crystal silicon layer, the thermal expansion thereof different from that of the supporting substrate is calculated (this value is referred to as thermal expansion difference 2). Subsequently, the groove width may be determined according to the value obtained by the equation below:

[Equation 2]     (thermal expansion difference 1 + thermal expansion difference 2)/2.

In particular, in the case in which the supporting substrate 500 forming a semiconductor mother substrate is composed of quartz, and a plurality of semiconductor substrates in a square shape having a side length of 40 mm is formed, when grooves having a width of 120 μm in the peripheries of the semiconductor substrates, heat treatment up to a temperature of 1,200°C can be performed. In addition, when heat treatment up to 1,000°C is performed, grooves having a width of 100 μm may be formed at the peripheries of the semiconductor substrates.

Furthermore, in the case in which grooves are formed around the semiconductor elements, grooves having a width of 0.1 μm may be formed around semiconductor elements each having a side length of 25 μm when heat treatment at 1,200°C is performed. Of course, for the sake of safety, grooves having a width of approximately one to several micrometers may be formed. In this embodiment, as long as the grooves are each formed so that the depth thereof extends to the insulating film 550 in the thickness direction, reliably no defects occur in the single crystal silicon layer 230 even when heat treatment is performed. In addition, the depth of the groove may be formed to be large so that misfit dislocation will not occur by thermal stress caused by heat treatment at a maximum temperature, and the depth described above can be determined by the difference in thermal expansion coefficient, and the thickness and the area of the single crystal silicon layer 230.

Next, as shown in Fig. 2(B), heat treatment is performed at approximately 700 to 1,200°C. This step is performed for increasing the bonding strength. In order to increase the adhesion at the interface at which the oxide films 210 and 510 of the semiconductor substrate 600 are bonded to each other, Si-O-Si bonds are formed by removing hydrogen present at the interface described above during the heat treatment.

The heat treatment is more preferably performed in the state in which the temperature in the semiconductor substrate 600 is increased in the direction toward one of the sides of the semiconductor substrate, whichever has a lower thermal expansion coefficient. As a result, the individual thermal expansions become approximately equivalent to each other, and as a result, the thermal stress is reduced. For example, the heat treatment may be performed unevenly for the semiconductor substrate by lamp annealing, laser annealing, annealing using microwaves, or the like.

In addition, since the single crystal silicon layer 230 is divided by the grooves 260, even when high-temperature annealing is performed, thermal stress generated by the difference in thermal expansion coefficient between the supporting substrate 500 and the single crystal silicon layer 230 can be reduced. Accordingly, the single crystal silicon layer 230 can maintain high-quality crystallinity without defects such as dislocation or cracking caused by the thermal stress. That is, annealing for sufficiently increasing the bonding strength can be performed.

In the bonded substrate 600 thus formed, a single crystal silicon layer having a different thickness in one part can be formed in accordance with the desired purposes. For example, a method in which, after the surface of the single crystal silicon substrate is selectively oxidized, this sacrifice oxide film obtained by this surface oxidation is removed by wet etching may be mentioned. According to this method, after the sacrifice oxide film is removed, a thin single crystal silicon layer remains in the area at which the sacrifice oxide film was previously formed; however, on the other hand, in the area at which the sacrifice oxide film was not formed, a thick single crystal silicon layer remains. The semiconductor substrate having the structure described above is a substrate particularly suitable for electrooptic devices. Since the grooves 260 for reducing the thermal stress are provided in the bonded substrate 600, the step of sacrifice oxidation can be performed. In addition, the heat treatment for improving the bonding strength can be performed by a sacrifice oxidation step.

In this embodiment, when the bonded substrate 600 (semiconductor substrate) having the SOI structure is formed, the single crystal silicon layer 230 is formed by forming the grooves 260 in the peripheries of predetermined regions of the single crystal silicon layer 220 (groove-forming step), and subsequently the semiconductor substrate 600 is processed by high-temperature annealing for improving the bonding strength (bonding strength-improving step). As a result, thermal stress caused by the difference in thermal expansion coefficient during high-temperature annealing can be reduced by the grooves 260, the defects are not generated in the single crystal silicon layer 230, and hence the semiconductor substrate 600, which has a high bonding strength and which comprises the single crystal silicon layer 230 having superior crystallinity, can be manufactured.

Accordingly, a sacrifice oxidation step can be performed on the single crystal silicon layer 220, and hence the bonded substrate 600 comprising the single crystal semiconductor layers 220 and 230, which have thicknesses different from each other, can be formed. As a result, various designs can be made for semiconductor devices formed on this bonded substrate 600; for example, a semiconductor device driven by a high current and at high frequency is formed on the thick second single crystal semiconductor layer 230, or a semiconductor device driven at a low voltage is formed on the thin first single crystal semiconductor layer 220. Consequently, since the bonded substrate 600 can provide a single crystal semiconductor layer having an optimum thickness for each semiconductor device formed thereon, the properties of the semiconductor devices can be fully utilized.

[Modification of Embodiment 1]

In Embodiment 1 described above, as shown in Fig. 2(C), it is preferable that a layer 520 which is formed of, for example, PSG (phosphosilicate glass), BSG (borosilicate glass), or BPSG (borophosphosilicate glass), and which has at least fluidity or elasticity during heat treatment at 1,200°C or less, be formed as at least a part of the insulating film 550. BPSG that is generally used in semiconductor processes has fluidity at 850°C or more. In addition, depending on the concentration of B or P, the fluidity can be obtained from a temperature of 700°C. Since the thermal stress can be reduced by this layer 520 having fluidity, this structure described above can be suitably used for an SOI substrate comprising materials having different thermal expansion coefficients. In addition, in the case described above, since the thermal stress can be sufficiently reduced without grooves, it is not necessary to form the grooves. When PSG, BSG, or BPSG is used for forming the fluid layer 520, in order not to adversely influence semiconductor elements formed on the single crystal silicon layer 230, a protective layer 530 formed of a silicon nitride film or the like may be formed at an upper side.

[Embodiment 2]

The method described in the above Embodiment 1 can be applied to methods for forming various semiconductor devices. Accordingly, in this embodiment, an example will be described in which an active matrix substrate (semiconductor device) of a liquid crystal device is formed by using the bonded substrate 600 described in Embodiment 1.

(Entire Structure of Liquid Crystal Device)

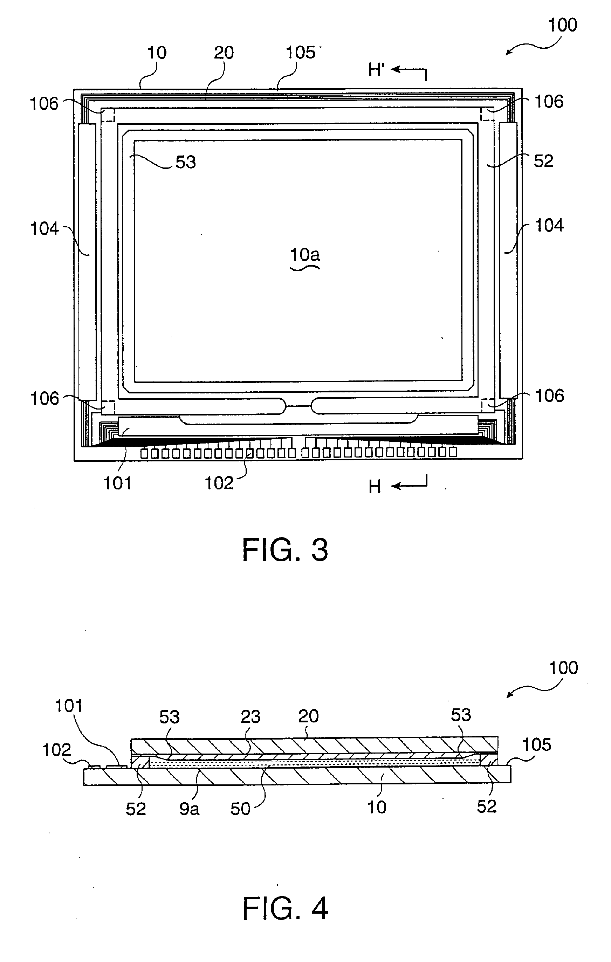

Fig. 3 is a plan view showing a liquid crystal device and various constituent elements formed thereon, which are viewed from a counter substrate side, and Fig. 4 is a cross-sectional view including the counter substrate taken along the line H-H' in Fig. 3.

As shown in Fig. 3, a sealing material 52 is provided along the periphery of an active matrix substrate 10 of a liquid crystal device 100, and inside the sealing material, a picture frame 53 composed of a shading material is formed. Outside the sealing material 52, a data line drive circuit 101 and an external output terminal 102 are provided along one side of the active matrix substrate 10, and scanning line drive circuits 104 are provided along two sides adjacent to the side mentioned above.

In the case in which delay of scanning signals supplied to scanning lines is not a problem, it is naturally understood that the scanning line drive circuit 104 may only be provided at one of the sides. In addition, the data line drive circuits 101 may be provided along two sides of an image display region 10a. For example, data lines in odd positions may supply image signals from one data line drive circuit provided on one side of the image display region 10a, and data lines in even positions may supply image signals from the other data line drive circuit on another side of the image display region 10a opposite to the side mentioned above. As described above, when the data lines are driven in a comb shape, since an area in which the data line drive circuit 101 is formed can be increased, a complicated circuit can be formed. Furthermore, at one remaining side of the active matrix substrate 10, a plurality of wires 105 for connecting the scanning line drive circuits 104 provided at the two sides of the image display region 10a to each other are provided, and in addition, a precharge circuit or a inspection circuit may be provided under the picture frame 53 or the like in some cases. In addition, in at least one of corner portions of a counter substrate 20, a vertical conductor 106 is provided for electrical connection between the active matrix substrate 10 and the counter substrate 20.

Next, as shown in Fig. 4, the counter substrate 20 having the outline approximately equivalent to that of the sealing material 52 shown in Fig. 3 is tightly bonded to the active matrix substrate 10 with this sealing material 52. This sealing material 52 is an adhesive composed of a photocurable resin or a thermosetting resin for bonding the active matrix substrate 10 and the counter substrate 20 to each other at the peripheries thereof and contains a gap material such as glass fibers or glass beads to maintain a constant distance between the two substrates.

Although details will be described later, pixel electrodes 9a are formed in a matrix on the active matrix substrate 10. In contrast, on the counter substrate 20, shading film 23 called a black matrix or a black stripe is formed so as to oppose longitudinal and lateral boundary regions of the pixel electrodes (described later) formed on the active matrix substrate 10, and on the upper side of the shading film, a counter electrode 21 formed of an ITO film is formed.

The liquid crystal device thus formed is used for, for example, a projection type liquid crystal apparatus (liquid crystal projector), which will be described later. In this case, three liquid crystal devices 100 are used as light valves for RGB, and individual color light components decomposed by dichroic mirrors for RGB color decomposition are incident on these liquid crystal devices 100 as projection light. Accordingly, no color filter is provided in the liquid crystal device 100 according to the embodiments described above.

However, when RGB color filters are provided together with a protective film therefor on the counter substrate 20 at positions opposing the individual pixel electrodes 9a, the liquid crystal device can be uses as a color liquid crystal display device of an electronic apparatus such as a mobile computer, a mobile phone, or a liquid crystal television, which will be described later in addition to a projection type liquid crystal apparatus.

In addition, when microlenses are provided for the counter substrate 20 so as to correspond to the individual pixels, condensation efficiency of light incident on the pixel electrodes 9a can be improved, and hence bright display can be performed. Moreover, several interference layers having different refractive indices from each other may be provided on the counter substrate 20 to form a dichroic filter for generating RGB color components using interference of light. By the counter substrate provided with the dichroic filter, a brighter color image can be displayed.

(Structure and Operation of Liquid Crystal Device 100)

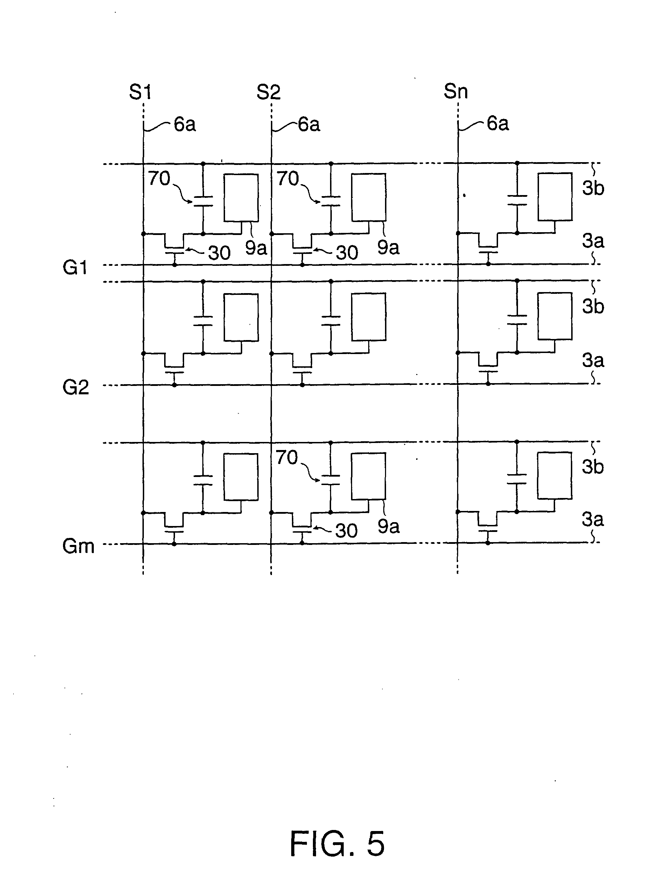

Next, the electrical structure and operation of an active matrix type liquid crystal device (electrooptic device) will be described with reference to Figs. 5 to 7.

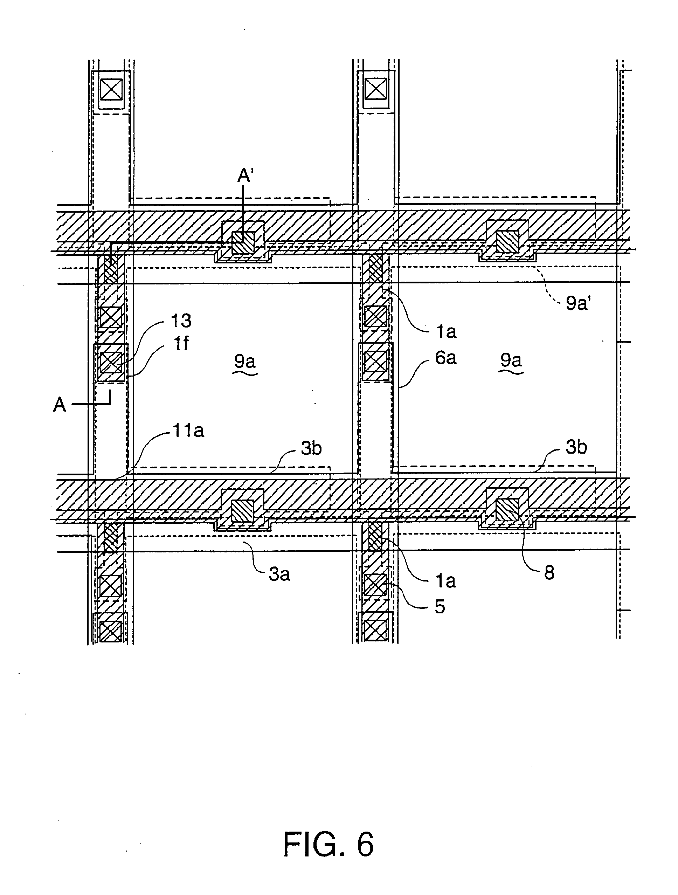

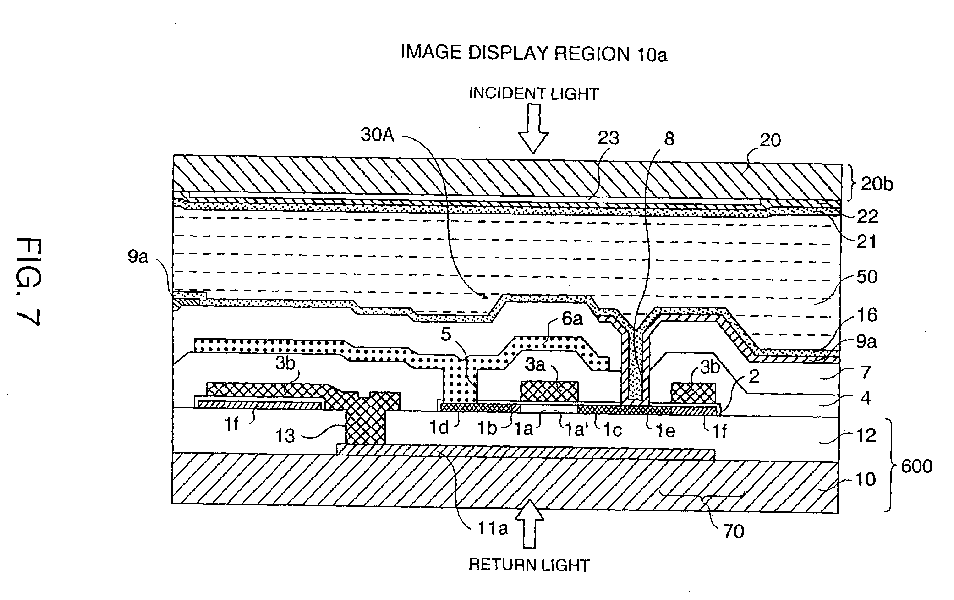

Fig. 5 is an equivalent circuit of various elements, wires, and the like of a plurality of pixels formed in a matrix for forming the image display region 10a of the liquid crystal device 100. Fig. 6 is a plan view showing pixels adjacent to each other on the active matrix substrate in which data lines, scanning lines, pixel electrodes, and the like are formed. Fig. 7 shows a cross-sectional view taken along the line A-A' in Fig. 6 and also illustrates the state in cross-section in which liquid crystal is enclosed as an electrooptic material between the active matrix substrate and the counter substrate. In order to recognize individual layers and members in the figures, the reduction scales thereof are changed from each other.

As shown in Fig. 5, in each of pixels formed in a matrix in the image display region 10a of the liquid crystal device 100, the pixel electrode 9a and a pixel switching MIS transistor 30 for controlling the pixel electrode 9a are formed, and data lines 6a supplying pixel signals are electrically connected to sources of the MIS transistors 30. Pixel signals S1, S2, ---, Sn to be written into the data lines 6a are sequentially supplied in that order. In addition, scanning lines 3a are electrically connected to gates of the MIS transistors 30, and pulse scanning signals G1 G2, ---, Gm are sequentially applied to the scanning lines 3a in that order at a predetermined timing. Since the pixel electrodes 9a are electrically connected to drains of the MIS transistors 30, when the MIS transistors 30 which are switching elements are placed in an On state for a predetermined period of time, the pixel signals S1 S2, ---, Sn supplied from the data lines 6a are written into the individual pixels at a given timing. The pixel signals S1, S2, ---, Sn at a predetermined level written into the liquid crystal via the pixel electrodes 9a are retained for a certain period of time between the pixel electrodes and the counter electrode, which will be described later, formed on the counter substrate.

In order to avoid leakage of the pixel signals thus retained, a storage capacitor 70 may be provided in parallel with a liquid crystal capacitance formed between the pixel electrodes 9a and the counter electrode in some cases. By these storage capacitors 70, the voltage of the pixel electrodes 9a is retained for, for example, a time which is three digits longer than that for a source voltage application. Accordingly, charge retention properties can be improved, and a liquid crystal device capable of creating high-contrast images can be realized. As a method for forming the storage capacitors 70, capacitors may be formed between capacitor lines 3b, which are wires for forming capacitance, or may be formed between the scanning lines 3a described above.

As shown in Fig. 6, on the active matrix substrate 10 of the liquid crystal device 100, a plurality of the transparent pixel electrodes 9a (the regions surrounded by the dotted lines) is formed in a matrix, each pixel electrode being provided in each pixel, and along the longitudinal and lateral boundaries of the pixel electrodes 9a, the data lines 6a (shown by the chain lines), the scanning lines 3a (shown by the solid lines), and the capacitor lines 3b (shown by the solid lines) are formed.

As shown in Fig. 7, the liquid crystal 100 comprises the active matrix substrate 10 and the counter substrate 20 opposing each other.

In this embodiment, a base body of the active matrix substrate 10 is formed of the bonded substrate 600 described later, and a base body of the counter substrate 20 is formed of a transparent substrate 20b such as a quartz substrate or a heat-resistance glass plate. The pixel electrodes 9a are formed on the active matrix substrate 10, and at the upper side of the pixel electrodes, an alignment film 16 processed by predetermined alignment treatment such as rubbing treatment is formed. The pixel electrodes 9a are each formed of a transparent conductive thin-film such as an ITO (Indium Tin Oxide) film. In addition, the alignment film 16 is formed by processing rubbing treatment on an organic thin-film such as a polyimide film. In the counter substrate 20, an alignment film 22 formed of a polyimide film is provided at the upper side of the counter electrode 21, and this alignment film 22 is also composed of a polyimide film processed by rubbing treatment.

In the image display region 10a of the active matrix substrate 10, at a position adjacent to each pixel electrode 9a, the pixel switching MIS transistor 30 performing switching control of each pixel electrode 9a is formed. In addition, inside the bonded substrate 600, a shading film 11a made of a chromium film or the like is formed in a region overlapping the MIS transistor 30 in plan view. At the surface side of the shading film 11a, an interlayer insulating film 12 is formed, and at the surface side of this interlayer insulating film 12, the MIS transistor 30 is formed. That is, the interlayer insulating film 12 is provided for electrically insulating a semiconductor layer 1a forming the MIS transistor 30 from the shading film 11a.

Referring to Figs. 6 and 7, the pixel switching MIS transistor 30 has an LDD (lightly doped drain) structure, and on the semiconductor layer 1a, a channel region 1a' at which a channel is formed by an electric field from the scanning line 3a, a lightly doped source region 1b, a lightly doped drain region 1c, a heavily doped source region 1d, and a heavily doped drain region 1e are formed. In addition, at the upper layer side of the semiconductor layer 1a, a gate insulating film 2 is formed for insulating this semiconductor layer 1a from the scanning line 3a.

The semiconductor layer 1a is a single crystal silicon layer formed by a method described later.

At the surface side of the MIS transistor 30 thus formed, interlayer insulating films 4 and 7 composed of a silicon oxide film are formed. On the surface of the interlayer insulating film 4, the data line 6a is formed, and this data line 6a is electrically connected to the heavily doped source region 1d via a contact hole formed in the interlayer insulating film 4. On the surface of the interlayer insulating film 7, the pixel electrode 9a composed of an ITO film is formed. The pixel electrode 9a is electrically connected to the heavily doped drain region 1e via a contact hole formed in the interlayer insulating films 4 and 7 and the gate insulating film 2. On the surface side of this pixel electrode 9a, the alignment film 16 composed of a polyimide film is formed. This alignment film 16 is a polyimide film processed by rubbing treatment.

In addition, since the capacitor line 3b as an upper electrode, which is formed of the same layer as that for the scanning line 3a, opposes an extending portion 1f (lower electrode) extending from the heavily doped drain region 1e with an insulating film (dielectric film), which is simultaneously formed with the gate insulating film 2a, provided therebetween, the storage capacitor 70 is formed.

As described above, the MIS transistor 30 preferably has the LDD structure; however, an offset structure in which implantation of dopant ions is not performed in regions corresponding to the lightly doped source region 1b and lightly doped drain region 1c may be formed instead. In addition, the MIS transistor 30 may be a self-aligned TFT in which heavily doped source and drain regions are formed in a self-alignment manner by implanting dopant ions at a high concentration using a gate electrode (part of the scanning line 3a) as a mask. Furthermore, in this embodiment, the MIS transistor 30 has the single gate structure in which only one gate electrode (scanning line 3a) is disposed between the source and the drain regions; however, at least two gate electrodes may be disposed therebetween. In the case described above, the structure is formed so that the same signal is applied to the individual gate electrodes. When the MIS transistor 30 having at least a dual gate (double gate), or a triple gate structure is formed, current leakage which occurs at the junction portion between the channel region and the source or the drain region can be avoided, and a current in an OFF state can be reduced. When at least one gate electrode has the LDD or the offset structure, an offset current can be further reduced, and hence a stable switching element can be obtained.

The active matrix substrate 10 and the counter substrate 20 thus formed are disposed so that the pixel electrodes 9a and the counter electrode 21 oppose each other, and in addition, liquid crystal 50 as an electrooptic material is enclosed and held in a space formed by the two substrates and the sealing material 52 (see Figs. 5 and 6). The liquid crystal 50 is placed in a predetermined alignment state by the alignment film when an electric field from the pixel electrode 9a is not applied. The liquid crystal 50 is formed of, for example, at least one nematic liquid crystal.

On each side of the counter substrate 20 and the active matrix substrate 10 on which light is incident or on each side thereof from which light is emitted, a polarizing film, a retardation film, and a polarizing plate may be disposed in predetermined directions in accordance with the type of the liquid crystal 50 to be used in an operating mode such as a TN (twisted nematic) mode or an STN (super TN) mode, and a display mode such as a normally white mode or a normally black mode.

(Structure of Drive Circuit)

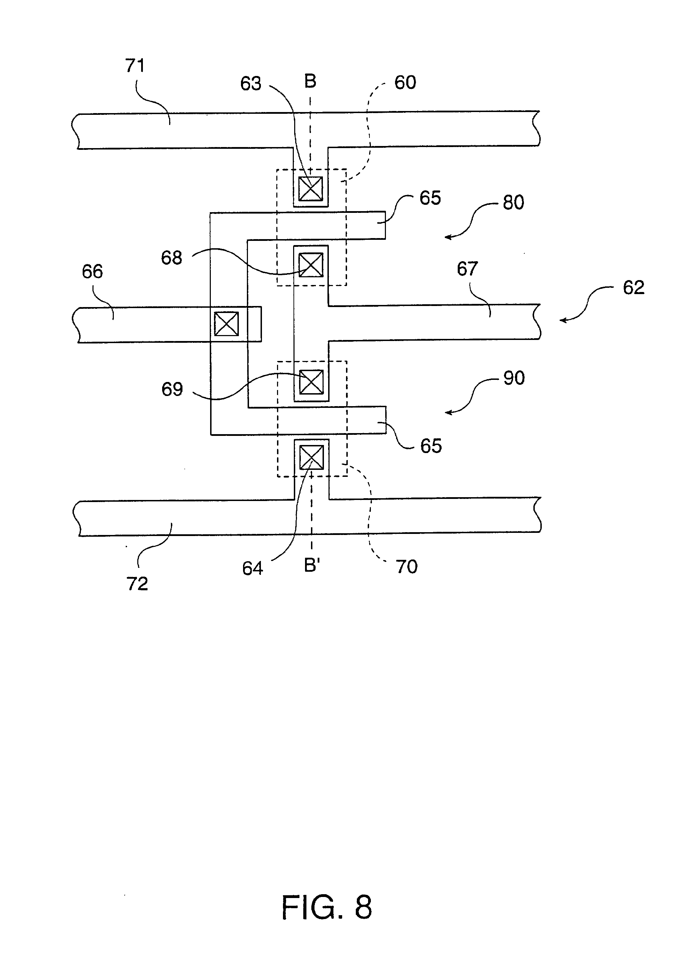

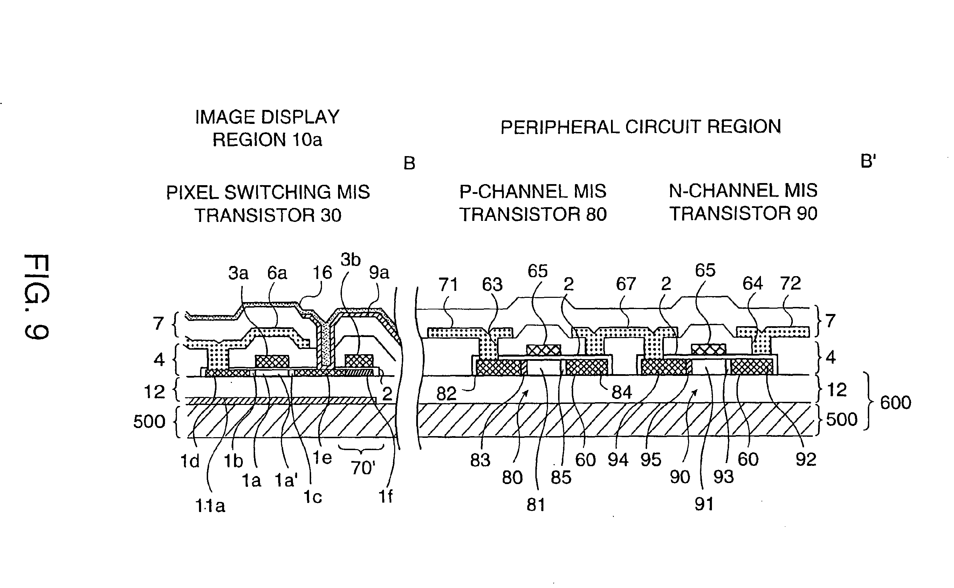

Again referring to Fig. 3, in the liquid crystal device 100 of this embodiment, the data line drive circuit 101 and the scanning line drive circuit 104 (peripheral circuit) are formed in the peripheral region of the image display region 10a formed on the surface side of the active matrix substrate 10. As described above, the data line drive circuit 101 and the scanning line drive circuit 104 are basically formed of N-channel MIS transistors and P-type MIS transistors shown in Figs. 8 and 9.

Fig. 8 is a plan view showing the configuration of the MIS transistors forming the peripheral circuits such as the scanning line drive circuit 104 and the data line drive circuit 101. Fig. 9 is a cross-sectional view of the structure of the MIS transistor forming this peripheral circuit taken along the line B-B' shown in Fig. 8. In Fig. 9, the pixel switching MIS transistor 30 formed in the image display region 10a on the active matrix substrate 10 is also shown.

As shown in Figs. 8 and 9, the MIS transistor forming the peripheral circuit is a complementary MIS transistor formed of a P-channel MIS transistor 80 and an N-channel MIS transistor 90. A semiconductor layer 60 (the outline thereof is shown by the dotted line) forming these drive circuit MIS transistors 80 and 90 is formed in an island shape above the bonded substrate 600 with the interlayer insulating film 12 provided therebetween.

In the MIS transistors 80 and 90, a high potential line 71 and a low potential line 72 are electrically connected to source regions of the semiconductor layer 60 via contact holes 63 and 64, respectively. In addition, an input line 66 is connected to a common gate electrode 65, and an output line 67 is electrically connected to drain regions of the semiconductor layer 60 via contact holes 68 and 69.

Since the peripheral circuit described above is formed by a process equivalent to that for the image display region 10a, the interlayer insulating films 4 and 7 and the gate insulating film 2 are formed in the peripheral circuit region. In addition, as is the pixel switching MIS transistor 30, the drive circuit MIS transistor 80 has the LDD structure in which on both sides of the channel regions 81, a source region formed of a heavily doped source region 82 and a lightly doped source region 83 and a drain region formed of a heavily doped drain region 84 and a lightly doped drain region 85 are provided. The drive circuit MIS transistor 90 also has the LDD structure in which on both sides of the channel regions 91, a source region formed of a heavily doped source region 92 and a lightly doped source region 93 and a drain region formed of a heavily doped drain region 94 and a lightly doped drain region 95 are provided.

As is the semiconductor layer 1a, the semiconductor layer 60 is a single crystal silicon layer formed by a method described later.

(Difference between Image Display Region and Peripheral Circuit Region)

In the image display region 10a and the peripheral circuit region thus formed, as can be seen from Fig. 9, the semiconductor layer 1a forming the pixel switching MIS transistor 30 is formed to be thinner than the semiconductor layer 60 forming the drive circuit MIS transistors 80 and 90. For example, the semiconductor layer 1a forming the pixel switching MIS transistor 30 is a single crystal silicon layer having a thickness of 100 nm or less, and the semiconductor layer 60 forming the drive circuit MIS transistors 80 and 90 is a single crystal silicon layer having a thickness of approximately 200 to 500 nm.

Accordingly, in the pixel switching MIS transistor 30, since the semiconductor layer 1a used therefor is thin, a light leakage current can be suppressed. In contrast, in the drive circuit MIS transistors 80 and 90, since the semiconductor layer 60 used therefor is thick, a high current is allowed to flow in accordance with low sheet resistance, and hence high-speed operation can be performed.

(Method for Manufacturing Active Matrix Substrate)

For forming the active matrix substrate 10 having the structure described above, the bonded substrate 600 is formed by using the method described in Embodiment 1. However, in this embodiment, as described below, the shading film 11a (see Fig. 7) is formed inside the bonded substrate 600.

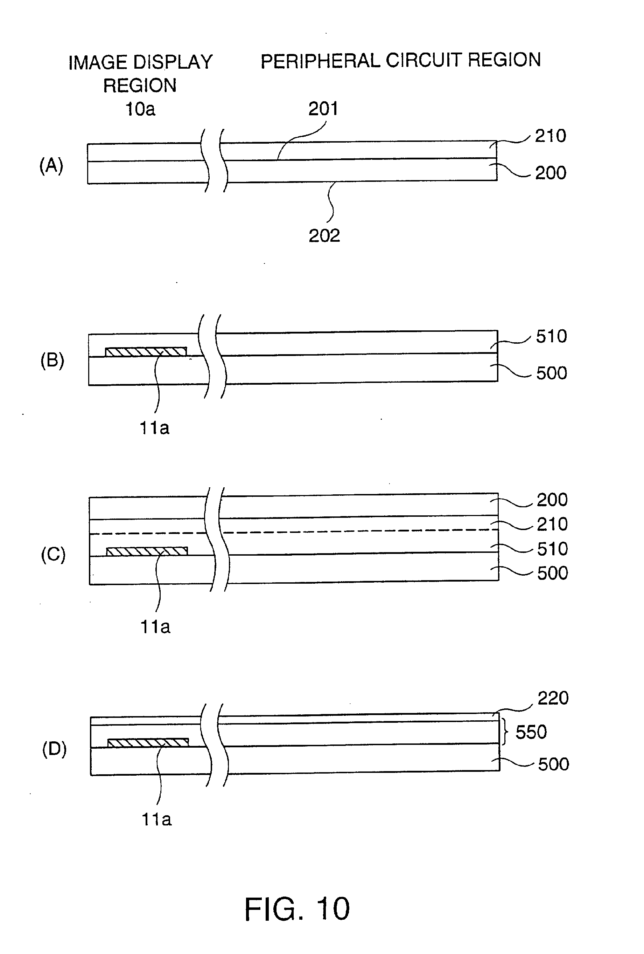

Figs. 10 to 14 include cross-sectional views showing steps of manufacturing method for the active matrix substrate 10 of this embodiment.

In this embodiment, as shown in Fig. 10(A), of the first surface 201 and the second surface 202 of the single crystal silicon substrate 200 (single crystal semiconductor substrate), the silicon oxide film 210 is formed at least on the entire first surface 201.

Next, as shown in Fig. 10(B), on the entire surface of the supporting substrate 500 having transparent properties, such as a quartz substrate or a heat-resistance glass substrate, a shading film such as a tungsten silicide film is formed, and this shading film is then patterned by a photolithographic technique, thereby forming the shading film 11a. Subsequently, after the oxide film 510, such as a silicon oxide film, non-doped silicate glass (NSG), phosphosilicate glass (PSG), borosilicate glass (BSG), or borophosphosilicate glass (BPSG), is formed on the entire surface of the supporting substrate 500 by the sputtering method, the CVD method or the like, the surface of this oxide film 510 is polished by a CMP method or the like, thereby planarizing the surface described above. In the step mentioned above, the thickness of the oxide film 510 is, for example, approximately 400 to 1,000 nm and is more preferably approximately 800 nm.

In addition, prior to the formation of the oxide film 510, the structure may be formed in which a protective layer composed of silicon nitride or the like is formed on the shading film 11a for suppressing chemical conversion such as oxidation thereof.

The supporting substrate 500 is preferably processed by pretreatment such as high-temperature annealing treatment in an inert gas atmosphere such as a nitrogen gas atmosphere at approximately 850 to 1,300°C and more preferably 1,000°C so as not to be distorted by a high-temperature process which will be performed later. That is, in consideration of a maximum temperature used among various manufacturing steps, the supporting substrate 500 is preferably processed beforehand by heat treatment at the maximum temperature mentioned above or more.

The oxide films 210 and 510 described above are provided to ensure the adhesion between the single crystal silicon substrate 200 and the supporting substrate 500.

Next, as shown in Fig. 10(C), by heat treatment at, for example, 300°C for 2 hours while the first surface 201 of the single crystal silicon substrate 200 is laminated to the surface of the supporting substrate 500 so that the oxide films 210 and 510 are in contact with each other, the single crystal silicon substrate 200 and the supporting substrate 500 are bonded together as shown in Fig. 10(D). In addition, the thickness of the single crystal silicon layer 220 is adjusted when necessary, thereby forming the bonded substrate 600 (semiconductor substrate) composed of the single crystal silicon layer 220 bonded to the supporting substrate 500 with the interlayer insulating film 12 (oxide films 210 and 510) provided therebetween (bonding step).

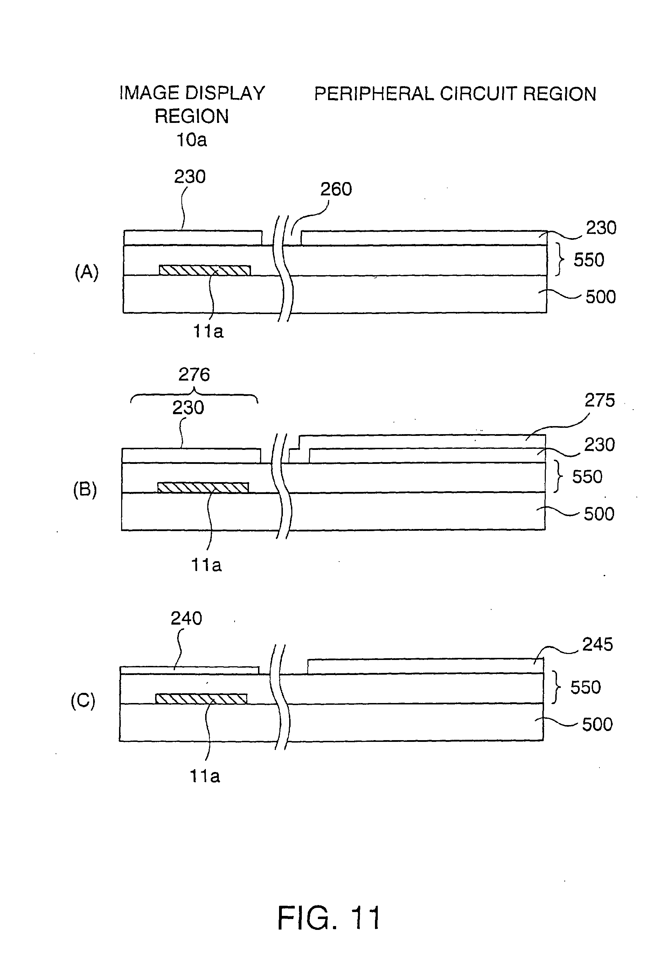

Next, as shown in Fig. 11(A), by using a photolithographic technique, the single crystal silicon layer 220 is patterned into island-shaped silicon layers 230. In this step, the grooves 260 are formed in the boundary region between the image display region 10a and the peripheral circuit region and in the peripheral region (dicing region), which is not shown in the figure, of the active matrix substrate 10.

Next, as shown in Fig. 11 (B), after a silicon nitride film 270 is formed, the silicon oxide film and the silicon nitride film are patterned by a photolithographic technique, thereby forming an oxidation-resistance mask layer 275 composed of the silicon nitride film. This oxidation-resistance mask layer 275 is provided with an opening 276 in a region corresponding to the image display region 10a of the liquid crystal device and covers the peripheral circuit region formed in the periphery of the image display region 10a. Between the oxidation-resistance mask layer 275 and the single crystal silicon layer 230, a thin silicon oxide film 250 for reducing stress or the like is provided. In this step, the silicon oxide film 250 may be omitted.

Next, as shown in Fig. 11(C), by heat treatment in an atmosphere containing steam, a portion of the single crystal silicon layer 230, which is exposed in the opening 276 formed in the oxidation-resistance mask layer 275, is oxidized, thereby forming a sacrifice oxide film 280 composed of a silicon oxide film (sacrifice oxidation step). Simultaneously, the boding strength is increased.

Next, the oxidation-resistance mask layer 275 composed of a silicon nitride film and a sacrifice oxide film are removed.

In the bonded substrate 600 thus formed, since the sacrifice oxide film 280 is formed by partly oxidizing the single crystal silicon layer 230, a thin first single crystal semiconductor layer 240 is left behind under the sacrifice oxide film 280 in the image display region 10a. In contrast, in the peripheral circuit region in which the sacrifice oxide film 280 is not formed on the single crystal silicon layer 230, a thick second single crystal semiconductor layer 245 having a thickness equivalent to that of the single crystal silicon layer 230 is formed, and the thickness thereof is considerably large compared to that of the first single crystal semiconductor layer 240.

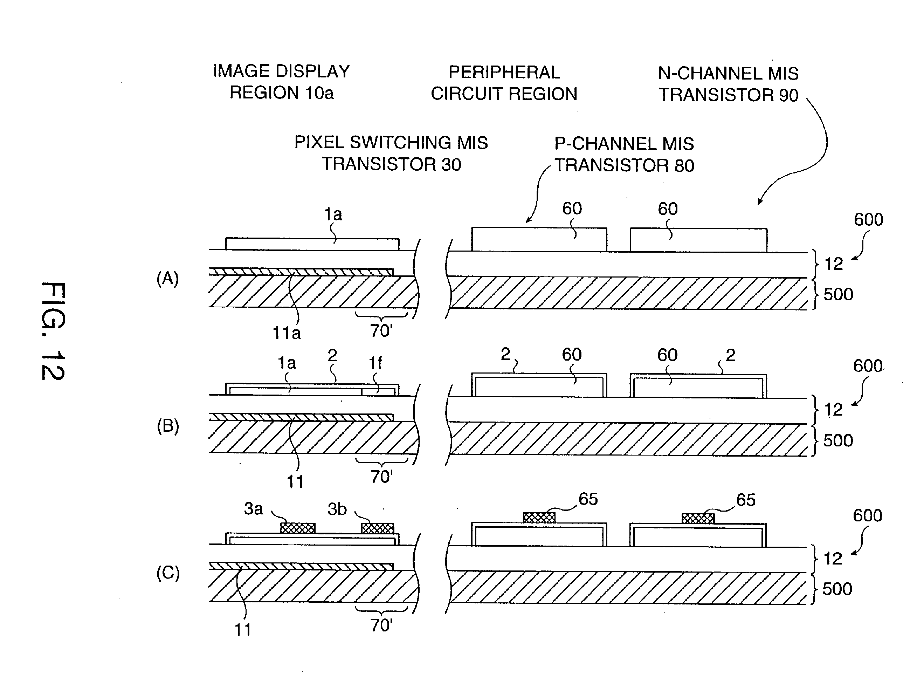

Next, as shown in Fig. 12(A), by using a photolithographic technique, the first and the second single crystal semiconductor layers 240 and 245 are patterned, thereby forming the semiconductor layer 1a constituting the pixel switching MIS transistor 30 and the island-shaped semiconductor layers 60 constituting the drive circuit MIS transistors 80 and 90. In this step, the semiconductor layer 1a constituting the pixel switching MIS transistor 30 is a single crystal silicon layer having a thickness of 100 nm or less, and the semiconductor layers 60 forming the drive circuit MIS transistor 80 and 90 are each a single crystal silicon layer having a thickness of approximately 200 to 500 nm.

Next, as shown in Fig. 12(B), by a thermal oxidation method or the like, the gate insulating films 2 each composed of a silicon oxide film are formed on the surfaces of the semiconductor layers 1a and 60. Although not shown in the figure, a lower electrode is formed for constituting the storage capacitor 70 between the capacitance line 3b and the extending portion 1f, which extends from the semiconductor layer 1a, by implanting dopant ions in the extending portion 1f using a predetermined resist mask.

Next, by a CVD method or the like, a conductive film approximately 350 nm thick composed of a polycrystalline silicon film, molybdenum film, a tungsten film, a titanium film, a cobalt film, or a silicide film of the film mentioned above is formed on an entire surface of a substrate for constituting the scanning lines 3a, the capacitance lines 3b, and the gate electrodes 65, and is subsequently patterned by a photolithographic technique as shown in Fig. 12(C), thereby forming the scanning lines 3a, the capacitance lines 3b, and the gate electrodes 65.

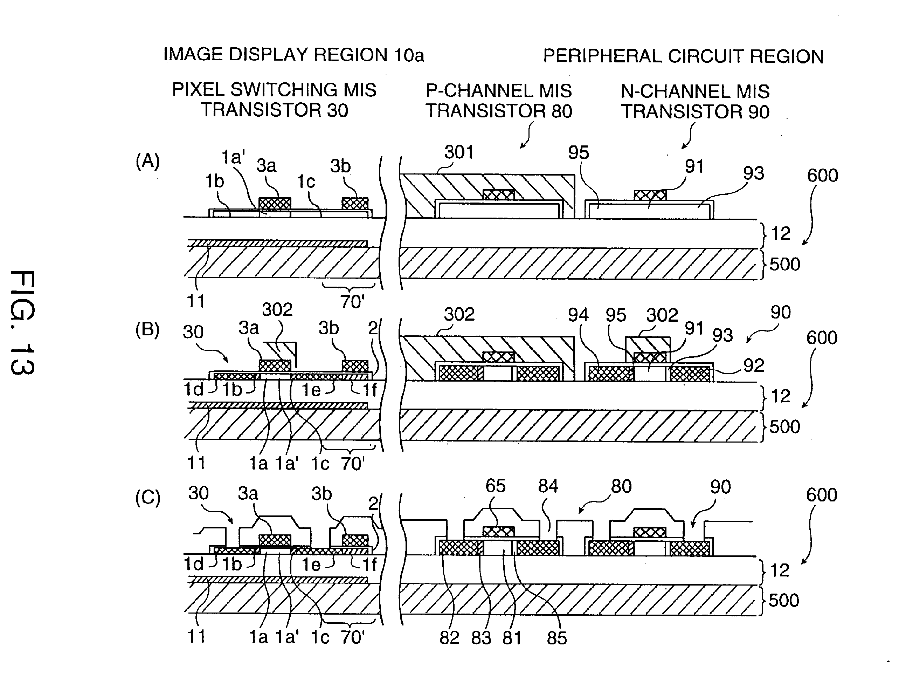

Next, as shown in Fig. 13(A), while the semiconductor layer 60 for forming the P-channel drive circuit MIS transistor 80 is covered with a resist mask 301, low-concentration dopant ions (phosphorus ions) are implanted at a dose rate of approximately $0.1 \times 10^{13}$ to $10 \times 10^{13}/cm^2$ in the semiconductor layer 1a for forming the pixel switching MIS transistor 30 and in the semiconductor layer 60 for forming the N-channel drive circuit MIS transistor 90 by using the scanning line 3a and the gate electrode 65 as a mask, thereby forming lightly doped source regions 1b and 93 and the lightly doped drain regions 1c and 95 on both sides of the scanning line 3a and the gate electrode 65, respectively, in a self-alignment manner. In this step, since being located under the scanning line 3a and the gate electrode 65, parts in which the dopant ions are not implanted are the semiconductor layers 1a and 60 themselves and are used as the channel regions 1a' and 91, respectively.

Next, as shown in Fig. 13(B), a resist mask 302 is formed which has a width larger than that of the scanning line 3a and the gate electrode 65 and which covers the semiconductor layer 60 for forming the P-channel drive circuit MIS transistor 80, and in the state described above, high-concentration dopant ions (phosphorus ions) are implanted at a dose rate of approximately $0.1 \times 10^{15}$ to $10 \times 10^{15}/cm^2$, thereby forming heavily doped source regions 1d and 92 and the heavily doped drain regions 1e and 94.

Although being not shown in the figure, boron ions are implanted at a dose rate of approximately $0.1 \times 10^{15}$ to $10 \times 10^{15}/cm^2$ in the semiconductor layer 60 for forming the P-channel drive circuit MIS transistor 80 by using the gate electrode 65 as a mask while the N-channel MIS transistors 30 and 90 sides are covered. Subsequently, with a mask having width larger than the width of the gate electrode 65, in addition to the lightly doped source region 83, the lightly doped drain region 85, and the channel region 81, the heavily doped source region 82 and the heavily doped drain region 84 are formed by implanting a high-concentration dopant (boron ions) at a dose rate of approximately $0.1 \times 10^{15}$ to $10 \times 10^{15}/cm^2$ in the semiconductor layer 60 forming the P-channel drive circuit MIS transistor 80 as shown in Fig. 13(C).

Next, after the interlayer insulating film 4 composed of a silicon oxide film or the like is formed at the surface side of the scanning line 3a by a CVD method or the like, by using a photolithographic technique, contact holes are formed.

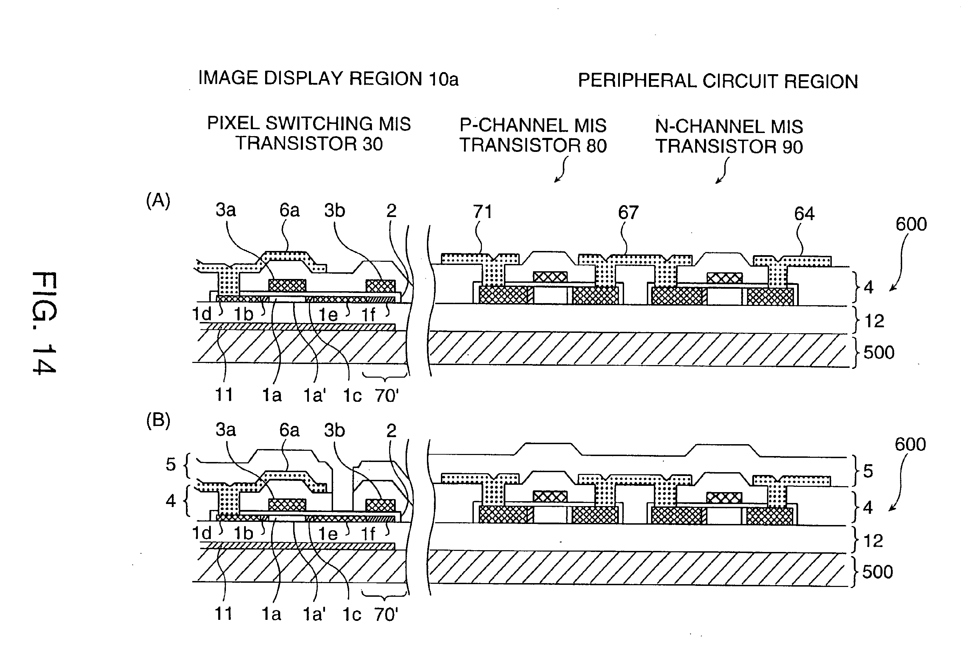

Next, as shown in Fig. 14(A), a conductive film approximately 350 nm thick made of an aluminum film, a titanium nitride film, a titanium film, or an alloy film primarily composed of any of the metals mentioned above is formed at the surface side of the interlayer insulating film 4 by the sputtering method in order to form the data line 6a (source electrode) or the like and is then patterned by a photolithographic technique, thereby forming the data line 6a, the high potential line 71, the low potential line 72, the input wire 66, and the output wire 67. As a result, in the peripheral circuit region, the P-channel and the N-channel MIS transistors 80 and 90 are formed.

Next, as shown in Fig. 14(B), after an interlayer insulating film 5 made of a silicon nitride film, a silicon oxide film, or the like is formed at the surface side of the data line 6a or the like by the plasma CVD method or the like, contact holes are formed in the interlayer insulating film 5 using a photolithographic technique.

Subsequently, as shown in Figs. 7 and 9, after the pixel electrode 9a having a predetermined pattern is formed, the alignment film 16 is formed. As a result, the active matrix substrate 10 is formed.

[Application to Electronic Apparatus]

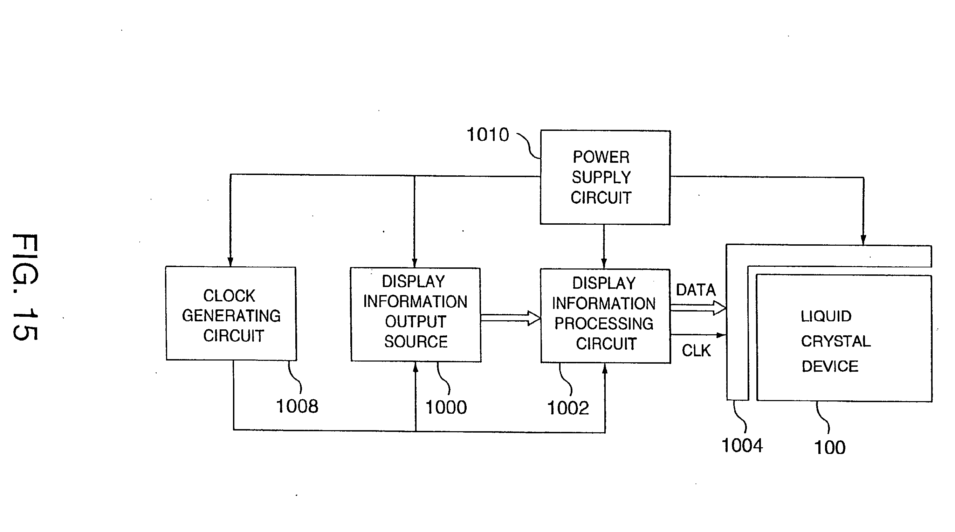

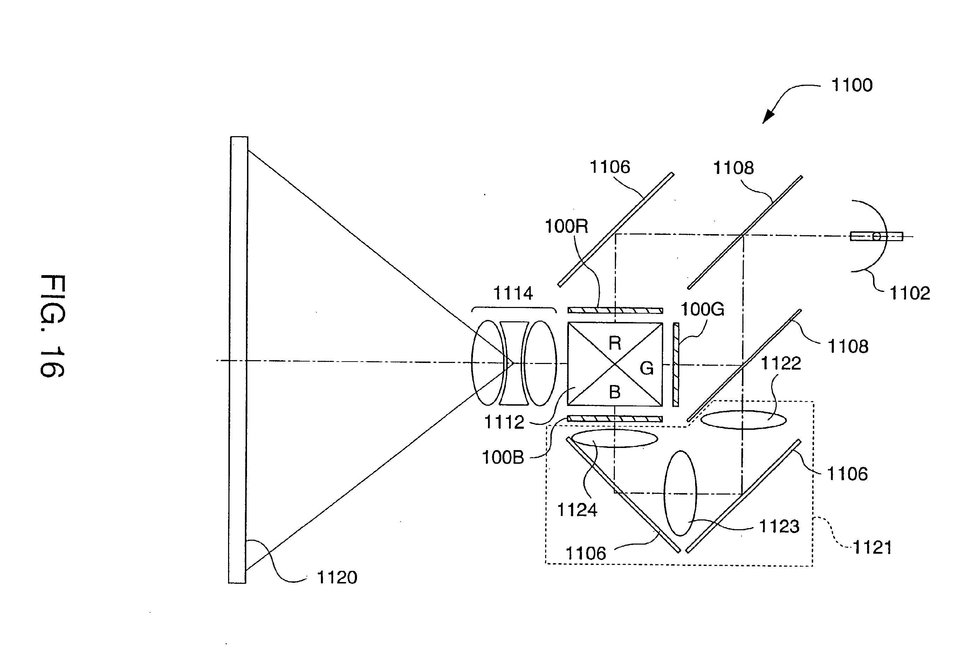

Next, referring to Figs. 15 and 16, a projection type liquid crystal display device will be described as an example of an electronic apparatus provided with the electrooptic device.

First, Fig. 15 is a block diagram of an electronic apparatus provided with a liquid crystal device 100 having the structure equivalent to that of the electrooptic device according to each embodiment described above.

In Fig. 15, the electronic apparatus has the structure comprising a display information output source 1000, a display information processing circuit 1002, a drive circuit 1004, a liquid crystal device 100, a clock generating circuit 1008, and a power supply circuit 1010. The display information output source 1000, which is constituted by memories such as a ROM (Read Only Memory), a RAM (Random Access Memory), or an optical disk; a tuning circuit for tuning pixel signals, which are television signals, and outputting them; and the like, processes image information having a predetermined format according to clock signals supplied from the clock generating circuit 1008 and outputs the processed display information to the display information processing circuit 1002. This display information processing circuit 1002 includes various known processing circuits, such as an amplifier/polarity inverting circuit, a phase developing circuit, a rotation circuit, a gamma correction circuit, or a clamping circuit, and the display information processing circuit 1002 sequentially generates digital signals from input display information in accordance with clock signals and outputs them to the drive circuit 1004 together with clock signals CLK. The drive circuit 1004 drives the liquid crystal device 100. The power supply circuit 1010 supplies predetermined electric powers to the individual circuits described above. In addition, the drive circuit 1004 may be formed on the active matrix substrate forming the liquid crystal device 100, and furthermore, the display information processing circuit 1002 may also be formed on the active matrix substrate.

As an electronic apparatus having the structure described above, there may be mentioned a projection type liquid crystal apparatus (liquid crystal projector) which will be described below with reference to Fig. 16.

A projection type liquid crystal display device 1100 shown in Fig. 16 includes three liquid crystal modules each having the liquid crystal device 100 with the drive circuit 1004 mounted on the active matrix substrate, and the liquid crystal modules, which are used as RGB light valves 100R, 100G, and 100 B, and form a projector. In this liquid crystal projector 1100, when light is emitted from a lamp unit 1102 formed of a white light source such as a metal halide lamp, by three mirrors 1106 and two dichroic mirrors 1108, light is separated into light components R, G, and B corresponding to the three primary colors R, G, and B (light separating means), respectively, and the light components R, G, and B are guided to the corresponding light valves 100R, 100G, and 100B (liquid crystal device 100/liquid crystal light valve), respectively. In this step, since having a long light path, the light component B is guided through a relay lens system 1121 formed of an entrance lens 1122, a relay lens 1123, and an exit lens 1124. The light components R, G, and B corresponding to three primary colors, modulated by the light valves 100R, 100G, and 100B, respectively, are incident on a dichroic prism 1112 (light synthesizing means) from three different directions, are again synthesized, and are projected to a screen 1120 through a projection lens 1114.

In the present invention, the technical scope thereof is not limited to those described in the above embodiments, and without departing from the scope of the present invention, various modification of the present invention can be performed. For example, the particular structures of the liquid crystal devices described in the embodiments are disclosed by way of example, and in addition to those, the present invention can be applied to liquid crystal devices having various structures. In addition, for example, it is naturally understood that the present invention can be applied to electrooptic devices using various electrooptic elements, such as an electroluminescent (EL) element, a digital micro mirror device (DMD), or an element using plasma light emission, fluorescent light by electron emission, or the like, and to an electronic apparatus using the electrooptic device described above.

[Advantages]

As has thus been described, in the method of the present invention for manufacturing the semiconductor substrate having the supporting substrate which has a first thermal expansion coefficient, the insulating layer formed on the supporting substrate, and the single crystal semiconductor layer which is formed on the insulating layer and which has a second thermal expansion coefficient, the method described above comprises forming the single crystal semiconductor layer; forming grooves in the periphery of the predetermined regions of the single crystal semiconductor layer; and subsequently performing heat treatment.

As a result, since the single crystal semiconductor layer is divided by the grooves formed in the periphery of the predetermined region, even when being generated due to the difference in thermal expansion coefficient, the thermal stress can be reduced in the groove regions. Accordingly, in an SOI substrate composed of a supporting substrate and a semiconductor layer having different thermal expansion coefficients from each other, a semiconductor substrate without defects can be manufactured even when heat treatment is performed.

As a result, since a single crystal semiconductor layer having thicknesses optimum for individual semiconductor devices formed on a semiconductor substrate can be provided, designing can be flexibly performed in which, among various semiconductor devices formed on the semiconductor substrate, a semiconductor device driven by a high current and at high frequency is formed on a thick second single crystal semiconductor layer, and a semiconductor device driven by a low voltage is formed on a thin first single crystal semiconductor layer. Accordingly, properties of semiconductor devices formed on the single crystal semiconductor layer can be fully obtained.

**Claims**

1.  A method for manufacturing a semiconductor substrate having a supporting substrate which has a first thermal expansion coefficient, an insulating layer formed on the supporting substrate, and a single crystal semiconductor layer which is formed on the insulating layer and which has a second thermal expansion coefficient, the method comprising:

    forming the single crystal semiconductor layer above the supporting substrate; forming a groove in the periphery of a predetermined region of the single crystal semiconductor layer; and subsequently performing heat treatment.

2.  A method for manufacturing a semiconductor substrate according to Claim 1, wherein the heat treatment is performed at a temperature in the range of 700 to 1,200°C.

3.  A method for manufacturing a semiconductor substrate according to Claim 1 or 2, wherein the periphery of the predetermined region is the outside periphery of the semiconductor substrate.

4.  A method for manufacturing a semiconductor substrate according to Claim 1 or 2, wherein the periphery of the predetermined region is an element isolation region.

5.  A method for manufacturing a semiconductor substrate according to one of Claims 1 to 4, wherein the width of the groove is larger than the difference in thermal expansion between the supporting substrate having the first thermal expansion coefficient and the single crystal semiconductor substrate having the second thermal expansion coefficient generated in the predetermined region during heat treatment of the semiconductor substrate.

6.  A method for manufacturing a semiconductor substrate according to one of Claims 1 to 5, wherein the heat treatment is performed in an oxidizing atmosphere.

7.  A method for manufacturing a semiconductor substrate according to Claim 6, wherein the thickness of the single crystal semiconductor layer is adjusted in the heat treatment performed in the oxidizing atmosphere.

8.  A method for manufacturing a semiconductor substrate having a supporting substrate which has a first thermal expansion coefficient, an insulating layer formed on the supporting substrate, and a single crystal semiconductor layer which is formed on the insulating layer and which has a second thermal expansion coefficient, the method comprising performing heat treatment of the semiconductor substrate in the state in which the temperature in the semiconductor substrate is increased in the direction toward one of the supporting substrate having the first thermal expansion coefficient and the single crystal semiconductor layer having the second thermal expansion coefficient, whichever has a lower thermal expansion coefficient.

9.  A semiconductor substrate manufactured by the manufacturing method according to one of Claims 1 to 8.

**10.** A semiconductor substrate comprising: a supporting substrate having a first thermal expansion coefficient; an insulating layer formed on the supporting substrate; and a single crystal semiconductor layer which is formed on the insulating layer and which has a second thermal expansion coefficient; wherein at least a part of the insulating layer is formed of a material having at least fluidity or elasticity during heat treatment at 1,200°C or less.

**11.** A semiconductor substrate according to Claim 9 or 10, wherein the single crystal semiconductor layer comprises single crystal silicon.

**12.** A semiconductor substrate according to one of Claims 9 to 11, wherein the supporting substrate is a light transparent substrate.

**13.** A semiconductor substrate according to one of Claims 9 to 11, wherein the supporting substrate is a glass substrate.

**14.** A semiconductor substrate according to one of Claims 9 to 11, wherein the supporting substrate is a quartz substrate.

**15.** A semiconductor substrate according to Claim 14, wherein the width of the groove formed in the periphery of the semiconductor substrate is 120 µm or more.

**16.** A semiconductor substrate according to Claim 14, wherein the width of the groove formed in the element isolation region is 0.1 µm or more.

**17.** An electrooptic device comprising: an electrooptic material provided between a semiconductor substrate according to one of Claims 11 to 16 and a counter substrate; a plurality of first switching elements formed in a matrix in an image display region of the single crystal semiconductor layer above the supporting substrate so as to correspond to arranged pixels;

a plurality of second switching elements which are disposed in a peripheral region of the image display region and which form at least a part of a peripheral circuit; and

wherein the thickness of the single crystal semiconductor layer which is in the image display region and forms said plurality of the first switching elements is smaller than the thickness of the single crystal semiconductor layer which is in the peripheral region and forms said plurality of the second switching elements.

**18.** An electronic apparatus comprising: a light source; an electrooptic device according to Claim 17 modulating light incident thereon from the light source in accordance with image information; and projection means for projecting light modulated by the electrooptic device.

FIG. 1

FIG. 2

FIG. 3

FIG. 4

FIG. 5

FIG. 6

FIG. 7

FIG. 8

FIG. 9

IMAGE DISPLAY
REGION
10a

PERIPHERAL CIRCUIT REGION

201

(A)

210
200

202

(B)

510
500

11a

(C)

200
210
510
500

11a

(D)

220
550
500

11a

FIG. 10

IMAGE DISPLAY
REGION
10a

PERIPHERAL CIRCUIT REGION

FIG. 11

FIG. 12

IMAGE DISPLAY
REGION 10a

PERIPHERAL
CIRCUIT REGION

N-CHANNEL MIS
TRANSISTOR 90

PIXEL SWITCHING MIS
TRANSISTOR 30

P-CHANNEL MIS
TRANSISTOR 80

(A)

1a

60    60

600

12
500

11a    70'

(B)

1a  2  1f

2  60    60  2

600

12
500

11    70'

(C)

3a    3b

65    65

600

12
500

11    70'

EP 1 286 392 A2

FIG. 13

IMAGE DISPLAY REGION 10a        PERIPHERAL CIRCUIT REGION

PIXEL SWITCHING MIS        P-CHANNEL MIS        N-CHANNEL MIS
TRANSISTOR 30              TRANSISTOR 80        TRANSISTOR 90

FIG. 14

FIG. 15

FIG. 16